# EUROPÄISCHE PATENTSCHRIFT

(11) **EP 1 489 291 B1**
(45) Veröffentlichungstag und Bekanntmachung des Hinweises auf die Patenterteilung: **17.05.2006**
(21) Anmeldenummer: 04014308.3
(22) Anmeldetag: 18.06.2004
(51) Int. Cl.: F02D 41/20, H01L 41/04

(54) **Verfahren und Anordnung zum Betreiben eines kapazitiven Stellgliedes**
Method and device for operating A CAPACITIVE ACTUATOR
Procédé et dispositif pour commander UN ACTIONNEUR CAPACITIF

(30) Priorität: 18.06.2003 DE 10327608
(43) Veröffentlichungstag der Anmeldung: 22.12.2004
(73) Patentinhaber: VW Mechatronic GmbH & Co. KG, 09366 Stollberg (DE)
(72) Erfinder: Aspelmayr, Josef, 93055 Regensburg (DE); Pirkl, Richard, 93047 Regensburg (DE); Schrod, Walter, 93057 Regensburg (DE); Wiehoff, Hans-Jörg, 93049 Regensburg (DE)
(74) Vertreter: Patentanwaltskanzlei WILHELM & BECK

(56) Entgegenhaltungen:
- EP-A- 0 246 357
- US-B2- 6 563 252

## Beschreibung

Die Erfindung betrifft ein Verfahren und eine Anordnung zum Betreiben eines kapazitiven Stellgliedes, wobei das Stellglied mechanisch mit einer einzustellenden Einrichtung gekoppelt ist. Die Erfindung betrifft insbesondere ein oder mehrere Piezoelemente, das oder die mechanisch mit einem Kraftstoffventil für ein kraftstoffbetriebenes Aggregat (z. B. für einen mit flüssigem Kraftstoff betriebenen Kraftfahrzeug-Antriebsmotor) gekoppelt ist/sind.

Derartige kapazitive Stellglieder werden durch Zuleiten und/oder Ableiten eines elektrischen Betätigungsstromes über eine unmittelbar mit dem Stellglied verbundene elektrische Leitung betätigt. D. h. sie verändern abhängig von der zugeführten oder abgeführten Ladung ihre Position oder Abmessungen, sodass die mit ihnen gekoppelte Einrichtung eingestellt wird, z. B. ein Ventil geöffnet oder geschlossen wird.

Insbesondere wenn das kapazitive Stellglied als Teil eines Kraftstoff-Einspritzsystems Verwendung findet, wird eine hohe, langzeitstabile Genauigkeit beim Zeitablauf der Betätigung gefordert, um einerseits zu jedem Zeitpunkt genau die richtige Einspritzungsmenge zu erhalten und andererseits zu hohe Geräuschemissionen zu vermeiden.

Aus der DE 199 44 733 A1 ist eine Vorrichtung zum Ansteuern eines kapazitiven Stellgliedes bekannt. Die Vorrichtung weist einen Transformator auf, dessen Sekundärwicklung über eine elektrische Leitung unmittelbar mit dem Stellglied verbunden ist. Im Sekundärkreis befindet sich in Reihe zu dem Stellglied geschaltet ein Messwiderstand, der die Messung eines Ladestromes erlaubt. In Abhängigkeit von dem Ladestrom und weiteren Messgrößen wie der Stellgliedspannung und dem primärseitigen Ladestrom kann die Auf- oder Entladung des Stellgliedes eingeregelt werden. Dies dient insbesondere dazu, den Betrieb unabhängig von Temperaturänderungen und von Toleranzen der Schaltung, insbesondere des Transformators, zu gestalten.

Konkret wird in der DE 199 44 733 A1 vorgeschlagen, Stromschwellwerte vorzugeben und diese mit den mittels der Messwiderstände ermittelten Lade- oder Entladungsströmen zu vergleichen.

Aus US 6,563,252 B2 ist ein Verfahren zum Betreiben eines kapazitiven Stellglieds bekannt, das mit einer einzustellenden Einrichtung gekoppelt ist. Die Einrichtung ist mechanisch mit einem Kraftstoffventil verbunden, wobei zur Betätigung des kapazitiven Stellglieds ein Betätigungsstrom über eine unmittelbar mit dem kapazitiven Stellglied verbundene elektrische Leitung dem kapazitiven Stellglied zugeleitet wird. Während der Ansteuerung des kapazitiven Stellglieds wird ein analoges Messsignal erzeugt, das einen elektrischen Betriebszustand des kapazitiven Stellglieds wiedergibt. Das analoge Messsignal wird bei der Steuerung und/oder Regelung des kapazitiven Stellglieds verwendet.

Aus EP 0 246 357 A1 ist ein Verfahren und eine Schaltungsanordnung zur Ansteuerung eines Einspritzventils bekannt, bei dem eine Magnetspule des Einspritzventils mithilfe eines Halbleiterschalters derart pulsierend an eine Betriebsspannung angelegt wird, dass während eines ersten Zeitabschnitts ein zum Öffnen des Einspritzventils ausreichender Strom fließt. Weiterhin wird die Magnetspule in der Weise angesteuert, dass sich ein an den ersten Zeitabschnitt anschließender, von der vorgesehenen Einspritzdauer abhängiger zweiter Zeitabschnitt ergibt, währenddessen ein zum Offenhalten des Ventils ausreichender Strom fließt. Der erste Zeitabschnitt wird durch Abschalten dann beendet, wenn der Strom durch einen nach einer vorgegebenen Funktion von der Betriebsspannung abhängigen Spitzenwert erreicht hat. Dabei wird die Spannung der Magnetspule erfasst, mithilfe eines Analog-DigitalWandlers in einen digitalen Wert umgewandelt und einem Prozessor zugeführt. Zudem wird der durch die Magnetspule fließende Strom erfasst, über einen Analog-Digital-Wandler in einen digitalen Wert umgewandelt und ebenfalls dem Prozessor zugeführt. In Abhängigkeit von der Spannung ermittelt der Prozessor aus einem nicht-flüchtigen Speicher einen Spitzenstrom, der der erfassten Spannung zugeordnet ist. Überschreitet der gemessene Strom den Spitzenstrom, wird die Spannungsversorgung der Magnetspule abgeschaltet.

Es ist eine Aufgabe der vorliegenden Erfindung, ein kostengünstiges und flexibles Verfahren der eingangs genannten Art bereitzustellen. Weiterhin soll eine entsprechende Anordnung bereitgestellt werden.

Die Aufgabe wird durch ein Verfahren mit den Merkmalen des Patentanspruchs 1 bzw. durch eine Anordnung mit den Merkmalen des Patentanspruchs 11 gelöst. Weiterbildungen sind Gegenstand der jeweils abhängigen Ansprüche.

Es ist möglich (wie z. B. bei dem oben beschriebenen Stand der Technik), während der Betätigung des kapazitiven Stellgliedes ein analoges Messsignal zu erzeugen und bei einer Steuerung und/oder Regelung des Betriebes des kapazitiven Stellgliedes zu verwenden. Dabei wird das Messsignal aus einer elektrischen Messgröße erzeugt, die einen elektrischen Betriebszustand und/oder elektrischen Betriebsvorgang der elektrischen Leitung und/oder des kapazitiven Stellgliedes wiedergibt. Die elektrische Messgröße ist beispielsweise der Ladestrom, mit dem das kapazitive Stellglied aufgeladen wird, der Entladungsstrom, mit dem das kapazitive Stellglied entladen wird, die elektrische Spannung des kapazitiven Stellgliedes und/oder die elektrische Ladung des kapazitiven Stellgliedes. Aufgrund der mechanischen Kopplung zwischen dem Stellglied und der einzustellenden Einrichtung stellen die genannten elektrischen Messgrößen aussagekräftige Informationen über die Reaktion der einzustellenden Einrichtung dar.

Es wird nun vorgeschlagen, das zunächst als analoges elektrisches Messsignal erfasste Messsignal in ein digitales Messsignal umzuwandeln und den zeitlichen Verlauf des digitalen Messsignals bei der Steuerung und/oder Regelung des Betriebes des kapazitiven Stellgliedes zu verwenden.

Der Begriff "Messsignal" umfasst auch den Fall einer Mehrzahl von Teil-Messsignalen, etwa Teil-Messsignale einer Mehrzahl von elektrischen Messgrößen wie Ladestrom, Ladespannung, Stellgliedspannung und Stellglied-Ladung.

Durch die Digitalisierung und die Berücksichtigung des zeitlichen Verlaufs des Messsignals steht der Informationsgehalt des Messsignals prinzipiell für eine Vielzahl weiterer Signalverarbeitungsschritte zur Verfügung. Von diesen Signalverarbeitungsschritten können bei einer konkreten Ausführungsform der Erfindung einer oder mehrere ausgeführt werden. Insbesondere ist es möglich, mathematische Algorithmen zu hinterlegen, unter deren Verwendung von einem digitalen Datenverarbeitungsprozessor der zeitliche Verlauf des Messsignals ausgewertet wird. Alternativ oder zusätzlich ist es möglich, Auswertungsinformation in digitaler Form zur Verfügung zu stellen, insbesondere zu speichern, und bei der Auswertung des zeitlichen Verlaufs zu verwenden. Die Auswertungsinformation wird insbesondere aus einer früheren Betriebsphase des kapazitiven Stellgliedes gewonnen, z. B. bei einer Eichung. Auch ist es möglich, bei einer konkreten Anordnung zum Betreiben des kapazitiven Stellgliedes die Art der Signalverarbeitung nachträglich zu ändern, indem lediglich eine andere Software geladen und verwendet wird.

Somit ist aufgrund der Digitalisierung des Messsignals die Auswertung insgesamt wesentlich flexibler. Weiterhin kann sie wesentlich genauer durchgeführt werden, da nicht lediglich einzelne Werte der elektrischen Betriebsgrößen, sondern ein zeitlicher Verlauf zumindest über einen zeitlichen Teilbereich des Betriebes zur Verfügung steht. Auch ist es kostengünstiger, eine Signalverarbeitung unter Verwendung eines digitalen Datenprozessors vorzunehmen, als analoge Messsignale mittels einer klassischen elektrischen Schaltung auszuwerten.

Vorzugsweise wird das digitale Messsignal nicht für die gesamte Betriebszeit des kapazitiven Stellgliedes erzeugt und/oder bei der Steuerung und/oder Regelung des Betriebes verwendet. Dem liegt der Gedanke zugrunde, dass es besonders aussagekräftige Teilabschnitte der Betriebszeit gibt, in denen es besonders leicht und besonders genau möglich ist, Abweichungen von einem gewünschten Betriebsverhalten zu erkennen und ggf. den Betrieb zu korrigieren. Insbesondere enthält das Messsignal während der Aufladung oder Entladung des kapazitiven Stellgliedes besonders viele Informationen, wohingegen es während einer Phase konstanter Stellglied-Ladung (Konstantphase) nur wenige Informationen enthält, da eine Konstantphase meist durch einen einzigen Messwert charakterisiert werden kann. Weiterhin können durch eine Beschränkung auf die aussagekräftigen Betriebsphasen Ressourcen (insbesondere Speicherplatz und Signal-Verarbeitungsleistung) gespart bzw. geschont werden. Insbesondere wenn eine Verarbeitungseinheit verwendet wird, die auch andere Aufgaben zu übernehmen hat, wie z. B. die Steuerung anderer Einrichtungen, führt dies zu einer erheblichen Entlastung und/oder es kann u. U. eine Verarbeitungseinheit mit geringeren Ressourcen verwendet werden.

Vorzugsweise wird der zeitliche Verlauf des digitalen Messsignals also für zumindest einen Teil-Zeitbereich des Betriebes des kapazitiven Stellgliedes bei der Steuerung und/oder Regelung des Betriebes des kapazitiven Stellgliedes verwendet.

Insbesondere ist der Teil-Zeitbereich kleiner als eine Dauer eines Betriebszyklus, in dem ein Betriebszustand der einzustellenden Einrichtung ausgehend von einem Ausgangszustand verändert wird und wieder zu dem Ausgangszustand zurückkehrt. Ein Beispiel hierfür ist ein Betriebszyklus, in dem ein mit dem kapazitiven Stellglied gekoppeltes Kraftstoffventil geöffnet und wieder geschlossen wird.

Bei einer Weiterbildung der Erfindung wird eine Lage des Teil-Zeitbereichs relativ zu einem wiederkehrenden charakteristischen Zeitpunkt und/oder eine Dauer des Teil-Zeitbereichs abhängig von dem Betriebzustand eines Gesamtsystems verändert, dessen Teil das kapazitive Stellglied ist, insbesondere abhängig von einer Betriebsgeschwindigkeit eines über das oben genannte Kraftstoffventil versorgten kraftstoffbetriebenen Motors. Dem liegt der Gedanke zugrunde, dass die Lage und/oder Dauer aussagekräftiger Teil-Zeitbereiche von dem Betriebszustand abhängt.

Die erfindungsgemäße Anordnung zum Betreiben eines kapazitiven Stellgliedes weist eine Erfassungseinrichtung zur Erzeugung eines analogen Messsignals während der Betätigung des kapazitiven Stellgliedes auf, wobei das analoge Messsignal einer erfassten elektrischen Messgröße entspricht, die einen elektrischen Betriebszustand und/oder elektrischen Betriebsvorgang der elektrischen Leitung und/oder des kapazitiven Stellgliedes wiedergibt. Ferner weist die Anordnung eine Steuerungs- und/oder Regelungseinrichtung zur Auswertung des Messsignals auf, wobei die Steuerungs- und/oder Regelungseinrichtung ausgangsseitig mit einer Betätigungseinrichtung zum Einstellen des Stromes verbunden ist, der durch die unmittelbar mit dem kapazitiven Stellglied verbundene elektrische Leitung fließt. Dabei kann die Einstellung des Stromes nach unterschiedlichen Kriterien erfolgen und sich insbesondere auch oder zusätzlich nach anderen der elektrischen Messgrößen richten als dem Ladestrom oder Entladestrom des kapazitiven Stellgliedes.

Es wird vorgeschlagen, einen Analog/Digital-Umwandler zur Umwandlung des analogen Messsignals in ein digitales Messsignal vorzusehen, wobei der Analog/Digital-Umwandler mit der Erfassungseinrichtung verbunden ist, wobei die Steuerungs- und/oder Regelungseinrichtung zur Auswertung des digitalen Messsignals ausgestaltet ist und wobei die Steuerungs- und/oder Regelungseinrichtung eingangsseitig mit dem Analog/Digital-Umwandler verbunden ist oder diesen umfasst.

Insbesondere kann eine Integriereinrichtung zur zeitlichen Integration des durch die elektrische Betätigungsleitung fließenden elektrischen Stroms eingangsseitig, in Signallaufrichtung vor dem Analog/Digital-Umwandler angeordnet und mit diesem verbunden sein. Alternativ oder zusätzlich kann eine Integriereinrichtung zur zeitlichen Integration des durch die elektrische Betätigungsleitung fließenden elektrischen Stroms ausgangsseitig, in Signallaufrichtung hinter dem Analog/Digital-Umwandler angeordnet und mit diesem verbunden sein. Z. B. kann diese Integriereinrichtung Teil der Steuerungs- und/oder Regelungseinrichtung sein.

Vorzugsweise ist die Anordnung ausgestaltet bzw. wird so betrieben, dass das erfindungsgemäße Verfahren in zumindest einer seiner Ausgestaltungen ausgeführt wird bzw. ausführbar ist.

Bei einer Ausgestaltung der Anordnung weist die Steuerungs- und/oder Regelungseinrichtung eine Vergleichseinrichtung zum Vergleichen des digitalen Messsignals mit Vergleichsinformation und einen Speicher zum Speichern der Vergleichsinformation auf, wobei die Vergleichseinrichtung eingangsseitig mit dem Analog/Digital-Umwandler verbunden ist und wobei der Speicher mit der Vergleichseinrichtung verbunden ist.

Die Erfindung wird nun anhand der beigefügten Zeichnung beispielhaft näher erläutert. Sie ist jedoch nicht auf die Beispiele beschränkt. Die einzelnen, schematisch zu verstehenden Figuren der Zeichnung zeigen:
- Fig. 1: ein kapazitives Stellglied und eine besonders bevorzugte Anordnung zum Betreiben des Stellgliedes,
- Fig. 2: eine Detaildarstellung eines Teils der Anordnung gemäß Fig. 1 und
- Fig. 3: zeitliche Verläufe von elektrischen Messgrößen während des Betriebes des kapazitiven Stellgliedes.

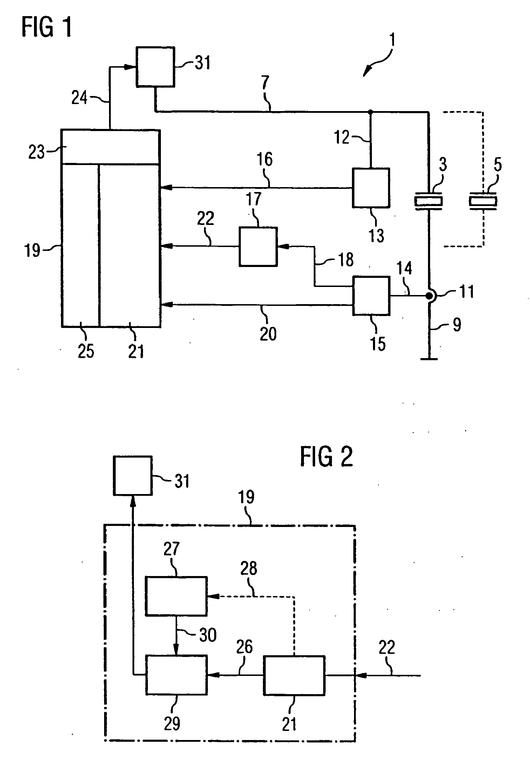

In Fig. 1 ist ein als piezoelektrisches Element ausgestaltetes kapazitives Stellglied 3 dargestellt. Ein oder mehrere weitere kapazitive Stellglieder (bezeichnet mit dem Bezugszeichen 5) können zusätzlich vorgesehen sein. Das oder diese Stellglieder werden dann elektrisch parallel zu dem Stellglied 3 geschaltet und sind vorzugsweise so angeordnet, dass sie insgesamt, zusammen mit dem Stellglied 3, einen größeren mechanischen Stellweg ermöglichen.

Sind mehrere kapazitive Stellglieder 3, beispielsweise zum Ansteuern mehrerer Kraftstoffventile, vorgesehen, so sind diese parallel zueinander angeordnet, wobei wie aus der DE 199 44 733 A1 bekannt jedem Stellglied ein hier nicht dargestellter Auswahlschalter in Reihe geschaltet ist.

Die folgenden Ausführungen beziehen sich der Einfachheit halber nur auf den Fall eines einzigen Stellgliedes 3. Sie gelten jedoch analog auch für den anderen Fall.

Eine Anordnung 1 zum Betreiben des Stellgliedes 3 weist eine Spannungs-Messeinrichtung 13 zur Messung einer elektrischen Spannung des kapazitiven Stellgliedes 3 auf. Die Spannungs-Messeinrichtung 13 ist über eine Messleitung 12 mit einer elektrischen Leitung 7 verbunden, die wiederum unmittelbar mit dem kapazitiven Stellglied 3 verbunden ist und über die ein Lade- oder Entladestrom zur Aufladung oder Entladung des kapazitiven Stellgliedes 3 fließen kann. Eine weitere unmittelbar mit dem kapazitiven Stellglied 3 verbundene elektrische Leitung 9 setzt an dem gegenüberliegenden Pol des Stellgliedes 3 an und verbindet diesen mit einem Bezugspotenzial. Mit der elektrischen Leitung 9 ist ein Stromsensor 11 zum Messen des Lade- oder Entladestromes des kapazitiven Stellgliedes 3 verbunden. Eine Strom-Messeinrichtung 15 greift über eine Messleitung 14 das analoge Messsignal des Stromsensors 11 ab.

Eine Betätigungseinheit 31, die mit der elektrischen Leitung 7 verbunden ist, dient dem Einstellen des durch die elektrischen Leitungen 7, 9 fließenden Stromes. Der Lade- und/oder Entladestrom des kapazitiven Stellgliedes 3 kann insbesondere wie aus der DE 199 44 733 A1 bekannt eingestellt werden. Die Betätigungseinrichtung 31 weist dann z. B. den aus der Druckschrift bekannten Transformator mit den zugehörigen Einrichtungen zum Betrieb des Transformator mittels Pulsweitenmodulation auf.

Die Betätigungseinheit 31, die Spannungs-Messeinrichtung 13 und/oder die Strom-Messeinrichtung 15 können bei alternativen Ausführungsformen der Anordnung jeweils mit der anderen elektrischen Leitung 7, 9 verbunden sein.

Die Anordnung 1 weist eine Verarbeitungseinrichtung 19 zur digitalen Datenverarbeitung auf. Teil-Einrichtungen der Verarbeitungseinrichtung 19 sind insbesondere ein Analog/Digital-Konverter (im Folgenden kurz: A/D-Konverter) 21 und eine Prozessoreinheit 23 zur eigentlichen digitalen Datenverarbeitung (z. B. ein oder mehrere miteinander verbundenen Mikroprozessoren). Mögliche weitere Komponenten der Verarbeitungseinrichtung 19 sind mit dem Bezugszeichen 25 bezeichnet.

Eingangsseitig ist der A/D-Konverter 21 über eine Signalleitung 16 mit der Spannungs-Messeinrichtung 13, über eine Signalleitung 20 mit der Strom-Messeinrichtung 15 und über eine Signalleitung 22 mit einer Integriereinrichtung 17 verbunden.

Die Integriereinrichtung 17 wiederum ist eingangsseitig über eine Signalleitung 18 mit der Strom-Messeinrichtung 15 verbunden und ist ausgestaltet, den von der Strom-Messeinrichtung 15 gemessenen Stromwert zeitlich zu integrieren und somit einen analogen Messwert der geflossenen elektrischen Ladung an den A/D-Konverter 21 auszugeben. Ist ein Wert der Ladung des kapazitiven Stellgliedes 3 zu einem früheren Zeitpunkt bekannt, so kann daher auf den aktuellen Ladungswert des Stellgliedes 3 geschlossen werden.

Bei einer alternativen Ausgestaltung ist eine Integriereinrichtung zur zeitlichen Integration des von der Strom-Messeinrichtung 15 gemessenen Stromwertes Teil der Verarbeitungseinrichtung 19. Insbesondere wird der Stromwert mittels Software gesteuert von der Prozessoreinheit 23 integriert. In diesem Fall entfällt die in Fig. 1 dargestellte Integriereinrichtung 17.

Ausgangsseitig ist die Verarbeitungseinrichtung 19 über eine Stellsignal-Leitung 24 mit der Betätigungseinheit 31 verbunden. Über die Stellsignal-Leitung 24 wird z. B. ein Pulsweitenmodulationssignal zur Einstellung des oben erwähnten Transformators übertragen.

Gemäß einem in Fig. 2 dargestellten speziellen Ausführungsbeispiel der Anordnung 1, das der derzeit bekannten besten Ausführungsform der Erfindung entspricht, weist die Verarbeitungseinrichtung 19 einen digitalen (insbesondere permanenten) Datenspeicher 27 und eine Vergleichseinrichtung 29 zum Vergleichen eines aktuellen zeitlichen Messsignal-Verlaufs mit in dem Datenspeicher 27 gespeicherter Vergleichsinformation auf. Der A/D-Konverter 21 ist über eine Signalleitung 26 mit der Vergleichseinrichtung 29 verbunden. Der Datenspeicher 27 ist über eine Signalleitung 30 mit der Vergleichseinrichtung 29 verbunden, um zumindest einen Teil der in ihm gespeicherten Information zu der Vergleichseinrichtung 29 zu übertragen. Während des Betriebes der Verarbeitungseinrichtung 19 kann die Information optional in einem flüchtigen Speicher der Vergleichseinrichtung 29 gespeichert sein.

Eine optional vorhandene Signalleitung 28 verbindet den A/D-Konverter 21 mit dem digitalen Datenspeicher 27. Ist die Signalleitung 28 vorhanden, kann entschieden werden, ob das Ausgangssignal des A/D-Konverters 21 dem Datenspeicher 27 zugeführt und somit gespeichert wird. Der Datenspeicher 27 kann die in ihm gespeicherten Daten bzw. Information aber auch oder ausschließlich aus einer anderen Quelle beziehen und/oder sie können von Anfang an fest gespeichert sein.

Weitere Einheiten der Verarbeitungseinrichtung 19, wie z. B. eine Steuereinheit zur Steuerung des Betriebes des Datenspeichers 27 sind der Übersichtlichkeit wegen in Fig. 2 nicht dargestellt. Die Vergleichseinrichtung 29 ist beispielsweise Teil der Prozessoreinheit 23 oder eines Verarbeitungsprozesses der Prozessoreinheit 23.

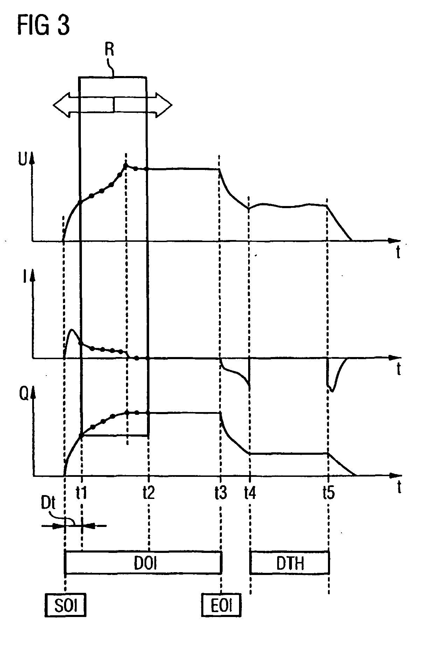

Ein besonders bevorzugtes Betriebsverfahren der anhand von Fig. 1 in Fig. 2 beschriebenen Anordnung 1 wird im Folgenden auch unter Bezugnahme auf Fig. 3 erläutert. Beispielhaft wird dabei davon ausgegangen, dass es sich bei dem kapazitiven Stellglied 3 um ein piezoelektrisches Element handelt, das mechanisch mit einem Kraftstoffventil eines Kraftstoff-Einspritzsystems gekoppelt ist. Ferner wird beispielhaft davon ausgegangen, dass von dem Kraftstoff-Einspritzsystem eine zyklisch, mit veränderlicher Drehzahl arbeitende Brennkraftmaschine eines Kraftfahrzeuges versorgt wird.

Während des Betriebes des piezoelektrischen Elements, der entsprechend dem Betrieb der Brennkraftmaschine zyklisch, mit wiederkehrenden ähnlichen oder gleichen Betätigungsabläufen durchgeführt wird, können Betriebsphasen mit Vollhub (d. h. voller Öffnung des Kraftstoffventils) und Betriebsphasen mit Teilhub (d. h. mit nur teilweiser Öffnung des Kraftstoffventils) in dem selben Betriebszyklus vorkommen. Ein solcher Verlauf von zunächst einer Vollhubphase DOI und von einer nachfolgenden Teilhubphase DTH ist für entsprechende elektrische Messgrößen des Stellglied-Betriebes in Fig. 3 dargestellt, und zwar für die Stellgliedspannung U, für den Ladestrom I (positive Werte) bzw. den Entladestrom (negative Werte) des Stellgliedes und für die geflossene Ladung Q, jeweils als Funktion der Zeit t.

Zum Zeitpunkt t = SOI (Start of Injection) beginnt die Vollhubphase DOI mit der Öffnung des Kraftstoffventils, d. h. mit der Betätigung des Stellgliedes 3. Zwar werden die analogen Messwerte von den Messeinrichtungen 13, 15, 17 kontinuierlich ermittelt und stehen jeweils an deren Ausgang als Messsignal zur Verfügung, jedoch werden die entsprechenden digitalen Messwerte nur für einen Abtastbereich R bei der Steuerung bzw. Regelung des Betriebes des Stellgliedes 3 von der Verarbeitungseinrichtung 19 verwendet. In dem hier beschriebenen Ausführungsbeispiel beginnt der Abtastbereich R erst nach t = SOI. Ein Grund hierfür ist, dass die Flanken der Messsignale der Stellgliedspannung U und der geflossenen Ladung Q unmittelbar nach t = SOI besonders groß sind und der Messfehler daher größer ist. Durch Vorgabe einer Verzugszeit Dt zwischen t = SOI und t = t1, dem Beginn des Abtastbereichs R, kann daher die Genauigkeit der Auswertung gesteigert werden. Umgekehrt ist jedoch darauf zu achten, dass die Verzugszeit Dt nicht zu groß ist, da die wesentliche Information des zeitlichen Verlaufs der Messsignale in deren Dynamik (d. h. in der Änderung der Messgrößen) liegt. Auch wenn keine Verzugszeit vorgegeben ist, muss der Abtastbereich R auf einem definierten Bezugszeitpunkt bezogen werden, z. B. auf t = SOI.

Während des Abtastbereichs R werden die von dem A/D-Konverter 21 aus den analogen Messsignalen erzeugten digitalen Messsignale (wie durch eine Mehrzahl von ausgefüllten Kreisen angedeutet) abgetastet und die Abtastwerte über die Signalleitung 26 der Vergleichseinrichtung 29 zugeführt. In der Vergleichseinrichtung 29 oder in einem damit kombinierten Arbeitsspeicher werden die Abtastwerte zumindest vorübergehend gespeichert, sodass der zeitliche Verlauf der jeweiligen Messgröße für den Abtastbereich R zur Auswertung zur Verfügung steht. Die Vergleichseinrichtung 29 vergleicht nun den zeitlichen Verlauf und/oder zumindest eine Kenngröße des zeitlichen Verlaufs mit der Vergleichsinformation. Abhängig von dem Ergebnis des Vergleichs wird die Betätigung des Stellgliedes 3 in einem folgenden, oder noch in demselben Betriebszyklus geändert oder wie bisher durchgeführt. Insbesondere wird die Betätigung des Stellgliedes 3 geändert, wenn bei dem Vergleich eine unerwünschte Abweichung zwischen dem zeitlichen Verlauf bzw. der zumindest einen Kenngröße und der Vergleichsinformation festgestellt wird. Stellt sich beispielsweise heraus, dass der Gradient der Messgröße, Strom, Spannung oder Ladung kleiner oder größer als ein abgespeicherter Vergleichsgradient ist, dann wird bei einer nächsten Ansteuerung die Strom-, die Spannungs- oder die Ladungsänderung entsprechend größer bzw. kleiner eingestellt.

Noch während dem Abtastbereich R ist der Vollhub des Stellgliedes 3 erreicht und beginnt eine Betriebsphase, während der die Messgrößen konstant sind. Das Ende des Abtastbereichs liegt bei t = t2. Die Vollhubphase DOI endet bei t = t3 = EOI (End of Injection). Ab diesem Zeitpunkt beginnt eine teilweise Schließung des Kraftstoffventils durch umgekehrte Betätigung des Stellgliedes 3, d. h. durch teilweises Entladen des Stellgliedes 3. Zum Zeitpunkt t = t4 beginnt eine weitere Betriebsphase, während der die Messgrößen konstant sind. Dies ist die Teilhubphase DTH, die zum Zeitpunkt t = t5 endet. Danach wird das Stellglied vollständig entladen und somit das Kraftstoffventil geschlossen.

Die oben beschriebene Verfahrensweise wird insbesondere entsprechend definierten Vorgaben wiederholt, z. B. für jeden Betriebszyklus oder alle n Betriebszyklen, wobei n eine natürliche Zahl ist. Ändert sich währenddessen die Drehzahl bzw. Betriebsgeschwindigkeit der Brennkraftmaschine wird die Länge der Verzugszeit Dt und/oder wird die Dauer des Abtastbereichs, die als Funktion/en der Betriebsgeschwindigkeit vorgegeben ist/sind, angepasst. Dies ist in Fig. 3 durch einen nach rechts und nach links weisenden Doppelpfeil oben in der Darstellung angedeutet. Entsprechende Vergleichsinformationen für verschiedene Betriebsgeschwindigkeitswerte oder - bereiche sind in dem Datenspeicher 27 abgelegt und stehen für einen Vergleich durch die Vergleichseinrichtung 29 mit dem aktuellen zeitlichen Verlauf der Messgrößen zur Verfügung.

Entsprechend kann zusätzlich oder alternativ bei anderen Ausführungsformen des Verfahrens ein Abtastbereich erst nach dem Ende der Vollhubphase bei t = t3 = EOI beginnen. In diesem Fall wird vorzugsweise der Zeitpunkt t = EOI als Bezugszeitpunkt für die Auswertung des für den Abtastbereich ermittelten zeitlichen Verlaufs der Messgrößen und/oder für eine etwaige Verzugszeit verwendet. SOI und EOI sind sinnvolle Bezugszeitpunkte, da sie in der Betriebs-Steuerungseinrichtung ohnehin zur Verfügung stehen oder ohnehin ermittelt werden.

Um Speicherkapazität und Rechenzeit zu sparen, wird vorgeschlagen, nicht alle Messgrößen für den gesamten Abtastbereich (d.h. für einen Auswertungszeitraum) mit der maximal möglichen Abtastrate und/oder vollständig abzutasten.

Gemäß einer ersten Variante wird während eines Betriebszyklus nur ein Teil der gemessenen elektrischen Messgrößen abgetastet, insbesondere nur eine der elektrischen Messgrößen. In anderen Betriebszyklen kann dann ein anderer Teil der elektrischen Messgrößen, insbesondere eine andere elektrischen Messgröße, abgetastet werden.

Gemäß einer zweiten Variante werden verschiedene der elektrischen Messgrößen während des selben Abtastbereichs alternierend abgetastet, z. B. wiederholt in der Reihenfolge U, Q, I.

Gemäß einer dritten Variante werden zumindest zwei Abtastbereiche während des selben Betriebszyklus verwendet. Während eines der Abtastbereiche wird immer nur eine der elektrischen Messgrößen oder nur ein Teil der elektrischen Messgrößen abgetastet.

Diesem Ansatz liegt der Gedanke zugrunde, dass der Informationsgehalt verschiedener Messgrößen bei zyklischer Betriebsweise des Stellgliedes in der Regel so groß ist, dass zumindest während eines Betriebszyklus oder für einen Abtastbereich auf einen Teil der Information verzichtet werden kann

Vorzugsweise wird bei Erfassung des Messsignals eine dem Messsignal überlagerte Schwingung in Bezug auf die Amplitude und die Frequenz erfasst. In Abhängigkeit von abgelegten Vergleichswerten für die überlagerte Schwingung wird bei der nächsten Ansteuerung des piezoelektrischen Elements die Ansteuerung in der Weise angepasst, dass eine Annäherung an die Amplitude und/oder die Frequenz der abgelegten Vergleichswerte erreicht wird.

## Patentansprüche

1. Verfahren zum Betreiben eines kapazitiven Stellgliedes (3, 5), wobei das Stellglied (3, 5) mechanisch mit einer einzustellenden Einrichtung gekoppelt ist, insbesondere zum Betreiben eines Piezoelements, das mechanisch mit einem Kraftstoffventil für ein kraftstoffbetriebenes Aggregat gekoppelt ist, wobei zur Betätigung des kapazitiven Stellgliedes (3, 5) elektrischer Betätigungsstrom über eine unmittelbar mit dem kapazitiven Stellglied (3, 5) verbundene elektrische Leitung (7, 9) dem kapazitiven Stellglied (3, 5) zugeleitet und/oder von dem kapazitiven Stellglied (3, 5) abgeleitet wird, wobei während der Betätigung ein analoges Messsignal erzeugt und bei einer Steuerung und/oder Regelung des Betriebes des kapazitiven Stellgliedes (3, 5) verwendet wird und wobei das Messsignal aus einer elektrischen Messgröße erzeugt wird, die einen elektrischen Betriebszustand und/oder elektrischen Betriebsvorgang der elektrischen Leitung und/oder des kapazitiven Stellgliedes (3, 5) wiedergibt,
**dadurch gekennzeichnet,**
**dass** das zunächst als analoges elektrisches Messsignal erfasste Messsignal in ein digitales Messsignal umgewandelt wird und dass der zeitliche Verlauf des digitalen Messsignals bei der Steuerung und/oder Regelung des Betriebes des kapazitiven Stellgliedes (3, 5) verwendet wird.

2. Verfahren nach Anspruch 1, wobei der zeitliche Verlauf des digitalen Messsignals für zumindest einen Teil-Zeitbereich des Betriebes des kapazitiven Stellgliedes bei der Steuerung und/oder Regelung des Betriebes des kapazitiven Stellgliedes (3, 5) verwendet wird.

3. Verfahren nach Anspruch 2, wobei der Teil-Zeitbereich kleiner ist als eine Dauer eines Betriebszyklus, in dem ein Betriebszustand der einzustellenden Einrichtung ausgehend von einem Ausgangszustand verändert wird und wieder zu dem Ausgangszustand zurückkehrt, insbesondere in dem das Kraftstoffventil geöffnet und wieder geschlossen wird.

4. Verfahren nach Anspruch 3, wobei ein zeitlicher Abstand zwischen dem Beginn des Betriebszyklus und dem Beginn des Teil-Zeitbereichs eingehalten wird.

5. Verfahren nach einem der Ansprüche 2 bis 4, wobei der Teil-Zeitbereich so gewählt wird, dass ein Zeitraum einer Betätigung des kapazitiven Stellgliedes (3, 5), insbesondere ein Zeitraum einer Öffnung des Kraftstoffventils, zumindest teilweise abgedeckt ist.

6. Verfahren nach einem der Ansprüche 2 bis 5, wobei eine Lage des Teil-Zeitbereichs relativ zu einem wiederkehrenden charakteristischen Zeitpunkt und/oder eine Dauer des Teil-Zeitbereichs abhängig von dem Betriebzustand eines Gesamtsystems verändert wird, dessen Teil das kapazitive Stellglied ist, insbesondere abhängig von einer Betriebsgeschwindigkeit eines über das Kraftstoffventil versorgten kraftstoffbetriebenen Motors.

7. Verfahren nach einem der Ansprüche 1 bis 6, wobei das analoge Messsignal aus einer Mehrzahl der elektrischen Messgrößen erzeugt wird und wobei nur ein Teil der Messgrößen mit einer maximal möglichen Abtastrate in das digitale Messsignal umgesetzt wird und bei der Steuerung und/oder Regelung des Betriebes des kapazitiven Stellgliedes (3, 5) verwendet wird.

8. Verfahren nach einem der Ansprüche 1 bis 7, wobei das analoge Messsignal aus einer Mehrzahl der elektrischen Messgrö-ßen erzeugt wird und wobei nur ein Teil der Messgrößen für einen Auswertungszeitraum vollständig in das digitale Messsignal umgesetzt wird und bei der Steuerung und/oder Regelung des Betriebes des kapazitiven Stellgliedes (3, 5) verwendet wird.

9. Verfahren nach einem der Ansprüche 1 bis 7, wobei der zeitliche Verlauf des digitalen Messsignals mit Vergleichsinformation verglichen wird.

10. Verfahren nach Anspruch 9, wobei die Vergleichsinformation aus einer früheren Betriebsphase des kapazitiven Stellgliedes (3, 5), insbesondere bei einer Eichung, gewonnen wird.

11. Anordnung zum Betreiben eines kapazitiven Stellgliedes (3, 5), wobei das Stellglied (3, 5) mechanisch mit einer einzustellenden Einrichtung gekoppelt ist, insbesondere zum Betreiben eines Piezoelements, das mechanisch mit einem Kraftstoffventil für ein kraftstoffbetriebenes Aggregat gekoppelt ist, wobei die Anordnung folgendes aufweist:
- eine unmittelbar mit dem kapazitiven Stellglied (3, 5) verbundene oder zu verbindende elektrische Leitung (7, 9), über die zur Betätigung des kapazitiven Stellgliedes (3, 5) elektrischer Betätigungsstrom dem kapazitiven Stellglied (3, 5) zugeleitet und/oder von dem kapazitiven Stellglied (3, 5) abgeleitet wird,
- eine Erfassungseinrichtung (13, 15, 17) zur Erzeugung eines analogen Messsignals während der Betätigung, wobei das analoge Messsignal einer erfassten elektrischen Messgröße entspricht, die einen elektrischen Betriebszustand und/oder elektrischen Betriebsvorgang der elektrischen Leitung und/oder des kapazitiven Stellgliedes (3, 5) wiedergibt, und
- eine Steuerungs- und/oder Regelungseinrichtung (19) zur Auswertung des Messsignals, wobei die Steuerungs- und/oder Regelungseinrichtung (19) ausgangsseitig mit einer Betätigungseinrichtung (31) zum Einstellen des durch die elektrische Leitung (7, 9) fließenden Stromes verbunden ist,
**gekennzeichnet durch,**
einen Analog/Digital-Umwandler (21) zur Umwandlung des analogen Messsignals in ein digitales Messsignal, wobei der Analog/Digital-Umwandler (21) mit der Erfassungseinrichtung (13, 15, 17) verbunden ist, wobei die Steuerungs- und/oder Regelungseinrichtung (19) zur Auswertung des digitalen Messsignals ausgestaltet ist und wobei die Steuerungs- und/oder Regelungseinrichtung (19) eingangsseitig mit dem Analog/Digital-Umwandler (21) verbunden ist oder diesen umfasst.

12. Anordnung nach Anspruch 11, wobei eine Integriereinrichtung (17) zur zeitlichen Integration des durch die elektrische Betätigungsleitung (7, 9) fließenden elektrischen Stroms eingangsseitig, in Signallaufrichtung vor dem Analog/Digital-Umwandler (21) angeordnet und mit diesem verbunden ist.

13. Anordnung nach Anspruch 11 oder 12, wobei eine Integriereinrichtung zur zeitlichen Integration des durch die elektrische Betätigungsleitung (7, 9) fließenden elektrischen Stroms ausgangsseitig, in Signallaufrichtung hinter dem Analog/Digital-Umwandler (21) angeordnet und mit diesem verbunden ist.

14. Anordnung nach einem der Ansprüche 11 bis 13, wobei die Steuerungs- und/oder Regelungseinrichtung (19) eine Vergleichseinrichtung (29) zum Vergleichen des digitalen Messsignals mit Vergleichsinformation und einen Speicher (27) zum Speichern der Vergleichsinformation aufweist, wobei die Vergleichseinrichtung (29) eingangsseitig mit dem Analog/Digital-Umwandler (21) verbunden ist und wobei der Speicher (27) mit der Vergleichseinrichtung (29) verbunden ist.

## Claims

1. Method for operating a capacitive actuator (3, 5), wherein the actuator (3, 5) is mechanically coupled to a device which is to be set, in particular for operating a piezoelectric element which is mechanically coupled to a fuel valve for a fuel-operated unit, with, for the purpose of actuating the capacitive actuator (3, 5), electrical actuating current being supplied to the capacitive actuator (3, 5) and/or discharged from the capacitive actuator (3, 5) via an electrical line (7, 9) which is connected directly to the capacitive actuator (3, 5), with an analogue measurement signal being generated during actuation and being used during open-loop and/or closed-loop control of the operation of the capacitive actuator (3, 5), and with the measurement signal being generated from an electrical measurement variable which reproduces an electrical operating state and/or electrical operating process of the electrical line and/or of the capacitive actuator (3, 5),
**characterized**
**in that** the measurement signal which is first detected as an analogue electrical measurement signal is converted into a digital measurement signal, and in that the time profile of the digital measurement signal is used during open-loop and/or closed-loop control of the operation of the capacitive actuator (3, 5).

2. Method according to Claim 1, wherein the time profile of the digital measurement signal is used for at least a partial time range of the operation of the capacitive actuator during open-loop and/or closed-loop control of the operation of the capacitive actuator (3, 5).

3. Method according to Claim 2, wherein the partial time range is shorter than the length of an operating cycle in which an operating state of the device which is to be set is changed starting from an initial state and returns to the initial state again, in particular in which the fuel valve is opened and closed again.

4. Method according to Claim 3, wherein a time difference is maintained between the beginning of the operating cycle and the beginning of the partial time range.

5. Method according to one of Claims 2 to 4, wherein the partial time range is selected such that a period of time for actuating the capacitive actuator (3, 5), in particular a period of time for opening the fuel valve, is at least partly covered.

6. Method according to one of Claims 2 to 5, wherein a position of the partial time range is changed in relation to a recurring characteristic time point and/or the length of the partial time range is changed as a function of the operating state of an overall system, of which the capacitive actuator is a part, in particular as a function of an operating speed of a fuel-operated motor which is supplied via the fuel valve.

7. Method according to one of Claims 1 to 6, wherein the analogue measurement signal is generated from a plurality of the electrical measurement variables, and wherein only some of the measurement variables are converted into the digital measurement signal at a maximum possible sampling rate and used during open-loop and/or closed-loop control of the operation of the capacitive actuator (3, 5).

8. Method according to one of Claims 1 to 7, wherein the analogue measurement signal is generated from a plurality of the electrical measurement variables, and wherein only some of the measurement variables for an evaluation period are completely converted into the digital measurement signal and used during open-loop and/or closed-loop control of the operation of the capacitive actuator (3, 5).

9. Method according to one of Claims 1 to 7, wherein the time profile of the digital measurement signal is compared with comparison information.

10. Method according to Claim 9, wherein the comparison information is obtained from an earlier operating phase of the capacitive actuator (3, 5), in particular during a calibration process.

11. Arrangement for operating a capacitive actuator (3, 5), wherein the actuator (3, 5) is mechanically coupled to a device which is to be set, in particular for operating a piezoelectric element which is mechanically coupled to a fuel valve for a fuel-operated unit, the arrangement having the following components:
- an electrical line (7, 9) which is or is to be connected directly to the capacitive actuator (3, 5) and via which the electrical actuating current is supplied to the capacitive actuator (3, 5) and/or discharged from the capacitive actuator (3, 5) for the purpose of actuating the capacitive actuator (3, 5),
- a detection device (13, 15, 17) for generating an analogue measurement signal during the actuation, with the analogue measurement signal corresponding to a detected electrical measurement variable which reproduces an electrical operating state and/or electrical operating process of the electrical line and/or of the capacitive actuator (3, 5), and
- an open-loop and/or closed-loop control device (19) for evaluating the measurement signal, with the output end of the open-loop and/or closed-loop control device (19) being connected to an actuating device (31) for the purpose of setting the current flowing through the electrical line (7, 9),
**characterized by**
an analogue/digital converter (21) for converting the analogue measurement signal into a digital measurement signal, with the analogue/digital converter (21) being connected to the detection device (13, 15, 17), with the open-loop and/or closed-loop control device (19) being designed to evaluate the digital measurement signal, and with the input end of the open-loop and/or closed-loop control device (19) being connected to the analogue/digital converter (21) or comprising the latter.

12. Arrangement according to Claim 11, wherein the input end of an integration device (17) for integrating over time the electrical current flowing through the electrical actuating line (7, 9) is arranged in the signal propagation direction upstream of the analogue/digital converter (21) and is connected to the latter.

13. Arrangement according to Claim 11 or 12, wherein the output end of an integration device for integrating over time the electrical current flowing through the electrical actuating line (7, 9) is arranged in the signal propagation direction downstream of the analogue/digital converter (21) and is connected to the latter.

14. Arrangement according to one of Claims 11 to 13, wherein the open-loop and/or closed-loop control device (19) has a comparison device (29) for comparing the digital measurement signal with comparison information, and a memory (27) for storing the comparison information, the input end of the comparison device (29) being connected to the analogue/digital converter (21), and the memory (27) being connected to the comparison device (29).

## Revendications

1. Procédé destiné au fonctionnement d'un organe de réglage capacitif (3, 5), l'organe de réglage (3, 5) étant couplé mécaniquement avec un dispositif à régler, notamment au fonctionnement d'un élément piézoélectrique, qui est couplé mécaniquement avec une vanne de carburant d'un système fonctionnant au carburant, du courant électrique d'actionnement pour l'actionnement de l'organe de réglage capacitif (3, 5) étant amené à l'organe de réglage capacitif (3, 5) et/ou capté sur l'organe de réglage capacitif (3, 5) par l'intermédiaire d'une ligne électrique (7, 9) reliée directement à l'organe de réglage capacitif (3, 5), un signal de mesure analogique étant généré pendant l'actionnement, et utilisé pour une commande et/ou une régulation du fonctionnement de l'organe de réglage capacitif (3, 5), et le signal de mesure étant généré à partir d'une grandeur de mesure électrique qui reflète un état de fonctionnement électrique et/ou un processus de fonctionnement électrique de la ligne électrique et/ou de l'organe de réglage capacitif (3, 5),
**caractérisé en ce que**
le signal de mesure détecté dans un premier temps en tant que signal de mesure analogique électrique est converti en un signal de mesure numérique, et **en ce que** l'évolution temporelle du signal de mesure numérique est utilisée pour la commande et/ou la régulation du fonctionnement de l'organe de réglage capacitif (3, 5).

2. Procédé selon la revendication 1, d'après lequel l'évolution temporelle du signal de mesure numérique est utilisée pour au moins une plage de temps partielle du fonctionnement de l'organe de réglage capacitif lors de la commande et/ou de la régulation du fonctionnement de l'organe de réglage capacitif (3, 5).

3. Procédé selon la revendication 2, d'après lequel la plage de temps partielle est inférieure à une durée d'un cycle de fonctionnement, au cours duquel un état de fonctionnement du dispositif à régler est modifié à partir d'un état initial et revient à nouveau à l'état initial, notamment au cours duquel la vanne de carburant est ouverte et à nouveau fermée.

4. Procédé selon la revendication 3, d'après lequel un intervalle de temps est respecté entre le début du cycle de fonctionnement et le début de la plage de temps partielle.

5. Procédé selon l'une des revendications 2 à 4, d'après lequel la plage de temps partielle est choisie de telle sorte qu'un laps de temps d'un actionnement de l'organe de réglage capacitif (3, 5), notamment un laps de temps d'une ouverture de la vanne de carburant, soit au moins partiellement couvert.

6. Procédé selon l'une des revendications 2 à 5, d'après lequel un état de la plage de temps partielle est modifié par rapport à un moment caractéristique récurrent et/ou à une durée de la plage de temps partielle en fonction de l'état de fonctionnement d'un système d'ensemble dont fait partie l'organe de réglage capacitif, notamment en fonction d'une vitesse de fonctionnement d'un moteur fonctionnant au carburant qui est alimenté par la vanne de carburant.

7. Procédé selon l'une des revendications 1 à 6, d'après lequel le signal de mesure analogique est généré à partir de plusieurs grandeurs de mesures électriques, et seule une partie des grandeurs de mesures avec un taux de balayage maximum possible étant convertie en le signal de mesure numérique, et utilisée pour la commande et/ou la régulation du fonctionnement de l'organe de réglage capacitif (3, 5).

8. Procédé selon l'une des revendications 1 à 7, d'après lequel le signal de mesure analogique est généré à partir de plusieurs grandeurs de mesures électriques, et seule une partie des grandeurs de mesures étant convertie entièrement en le signal de mesure numérique pour un intervalle de temps d'évaluation, et utilisée pour la commande et/ou la régulation du fonctionnement de l'organe de réglage capacitif (3, 5).

9. Procédé selon l'une des revendications 1 à 7, d'après lequel l'évolution temporelle du signal de mesure numérique est comparée avec une information de comparaison.

10. Procédé selon la revendication 9, d'après lequel l'information de comparaison est obtenue d'une phase de fonctionnement précédente de l'organe de réglage capacitif (3, 5), notamment lors d'un étalonnage.

11. Agencement destiné au fonctionnement d'un organe de réglage capacitif (3, 5), l'organe de réglage (3, 5) étant couplé mécaniquement avec un dispositif à régler, notamment au fonctionnement d'un élément piézoélectrique, qui est couplé mécaniquement avec une vanne de carburant d'un système fonctionnant au carburant, l'agencement comportant ce qui suit :
- une ligne électrique (7, 9) reliée ou à relier directement à l'organe de réglage capacitif (3, 5), par l'intermédiaire de laquelle du courant électrique d'actionnement pour l'actionnement de l'organe de réglage capacitif (3, 5) est amené à l'organe de réglage capacitif (3, 5) et/ou évacué de l'organe de réglage capacitif (3, 5),
- un dispositif de détection (13, 15, 17) pour générer un signal de mesure analogique pendant l'actionnement, le signal de mesure analogique correspondant à une grandeur de mesure électrique détectée, qui reflète un état de fonctionnement électrique et/ou un processus de fonctionnement électrique de la ligne électrique et/ou de l'organe de réglage capacitif (3, 5), et
- un dispositif de commande et/ou de régulation (19) pour l'évaluation du signal de mesure, le dispositif de commande et/ou de régulation (19) étant relié du côté de la sortie à un dispositif d'actionnement (31) pour le réglage du courant circulant dans la ligne électrique (7, 9),
**caractérisé par**
un convertisseur analogique / numérique (21) pour la conversion du signal de mesure analogique en un signal de mesure numérique, le convertisseur analogique / numérique (21) étant relié au dispositif de détection (13, 15, 17), le dispositif de commande et/ou de régulation (19) étant agencé pour l'évaluation du signal de mesure numérique, et le dispositif de commande et/ou de régulation (19) étant relié du côté de l'entrée au convertisseur analogique /numérique (21), ou comprenant celui-ci.

12. Agencement selon la revendication 11, dans lequel un dispositif d'intégration (17), pour l'intégration temporelle du courant électrique circulant dans la ligne d'actionnement électrique (7, 9), est disposé du côté de l'entrée en amont du convertisseur analogique / numérique (21) dans le sens de propagation du signal, et est relié à celui-ci.

13. Agencement selon la revendication 11 ou 12, dans lequel un dispositif d'intégration, pour l'intégration temporelle du courant électrique circulant dans la ligne d'actionnement électrique (7, 9), est disposé du côté de la sortie en aval du convertisseur analogique / numérique (21) dans le sens de propagation du signal, et est relié à celui-ci.

14. Agencement selon l'une des revendications 11 à 13, dans lequel le dispositif de commande et/ou de régulation (19) comporte un dispositif de comparaison (29) pour la comparaison du signal de mesure numérique avec une information de comparaison, et une mémoire (27) pour la mémorisation de l'information de comparaison, le dispositif de comparaison (29) étant relié du côté de l'entrée au convertisseur analogique / numérique (21), et la mémoire (27) étant reliée au dispositif de comparaison (29).
